# FASCICULE DE BREVET EUROPEEN

(11) **EP 0 660 650 B1**
(45) Date de publication et mention de la délivrance du brevet: **19.06.1996**
(21) Numéro de dépôt: 94402994.1
(22) Date de dépôt: 22.12.1994
(51) Int. Cl.: H05K 3/34, H05K 1/11

(54) **Plaque de circuit imprimé comportant des plages de drainage de soudure perfectionnées**
Leiterplatte mit verbesserten Lotdrainageflecken
Printed circuit board having improved solder drainage pads

(30) Priorité: 24.12.1993 FR 9315645
(43) Date de publication de la demande: 28.06.1995
(73) Titulaire: MAGNETI MARELLI FRANCE, F-92000 Nanterre (FR)
(72) Inventeur: Reau, Jean-Paul, F-86530 Naintre (FR)
(74) Mandataire: Martin, Jean-Jacques

(56) Documents cités:
- EP-A- 0 306 930
- DE-A- 3 614 366
- FR-A- 2 680 070
- IBM TECHNICAL DISCLOSURE BULLETIN., vol.32, no.11, Avril 1990, NEW YORK US pages 224 - 226, XP000097681 'Method to control solder volume and bridging on printed circuit surface patterns and preserve processing freedom'

## Description

La présente invention concerne le domaine des plaques de circuit imprimé.

Plus précisément la présente invention concerne les plaques de circuit imprimé conçues pour être soumises à une soudure à la vague.

On sait que la technique de soudure à la vague de composants, sur une plaque de circuit imprimé, consiste à déplacer la carte équipée desdits composants, sur un bain de soudure en fusion en soumettant cette plaque à une vague de soudure.

Afin d'éviter une accumulation de soudure sur les plages de connexion, notamment pour supprimer les risques de liaison électrique entre des plages de connexion voisines, on a déjà proposé de former en aval des plages métallisées de connexion, par rapport au sens de déplacement de la plaque, des plages métallisées dites de "drainage», séparées des plages de connexion. Ces plages de drainage ne jouent aucun rôle de connexion électrique. Leur seule fonction est de retenir par capillarité la soudure déposée en excès sur une plage de connexion voisine.

Par "aval" par rapport au sens de déplacement de la plaque, il faut entendre l'extrémité d'une plage de connexion recevant en dernier la soudure, lors du passage à la vague.

Cette technique de plages de drainage, bien qu'ancienne, ne donne pas totalement satisfaction.

En particulier, si elle permet effectivement de drainer une partie de la soudure en excès sur une plage de connexion, on constate cependant qu'elle ne permet pas généralement de garantir une épaisseur de soudure parfaitement constante sur toute la longueur de celle-ci. De fait on constate qu'il demeure généralement une surépaisseur de soudure au niveau du bord aval des plages de connexion.

Une telle surépaisseur est parfois très préjudiciable à la qualité du contact électrique obtenu, notamment par exemple lorsque les plages de connexion du circuit imprimé sont destinées à recevoir, par montage à baïonnette ou équivalent, les contacts d'une ampoule électrique ou les contacts d'un support recevant celle-ci.

Un tel mode de connexion entre une ampoule électrique et une plaque de circuit imprimé, est en particulier classique dans le domaine des tableaux de bord de véhicules automobiles, auquel s'applique préférentiellement la présente invention.

On a bien entendu tenté d'éliminer ces inconvénients de la technique antérieure.

En particulier, comme décrit dans le document FR-A-2 680 070, on a proposé pour celà d'incliner le canal séparant les plages de connexion et les plages de drainage, par rapport à la direction de passage à la vague, typiquement d'un angle supérieur à 15°.

L'expérience montre cependant que cette proposition ne donne pas non plus totalement satisfaction.

Le document DE-A-3614366 propose de scinder des plages de drainage en différents éléments séparés entre eux, allongés et alignés selon la direction de déplacement du circuit imprimé pour la soudure à la vague, ou encore de conformer ces plages de drainage en forme de peigne dont les dents sont disposées dans les intervalles des plages utiles de soudure.

Le document IBM Technical Disclosure Bulletin, vol. 32, n° 11, Avril 1990, propose de scinder chaque plage de connexion en éléments de base de contour carré.

Le document EP-A-306930 propose un circuit imprimé comprenant des plages de connexion inclinées à 45° par rapport à la direction de déplacement du circuit imprimé et agencées en rectangle, ainsi que des plages absorbantes, de forme triangulaire, dont le rôle est de récupérer l'excédent de soudure, positionnées dans les angles du rectangle, pour éviter les courts-circuits entre les pistes et les plages de connexion.

La présente invention a maintenant pour but de perfectionner la technique connue de fabrication des circuits imprimés comportant des plages dites de drainage.

Ce but est atteint dans le cadre de la présente invention, grâce à une plaque de circuit imprimé du type connu comprenant une plage métallisée de drainage en aval de certaines au moins des plages métallisées de connexion, par rapport au sens de déplacement de la plaque, pour un passage à la vague caractérisé par le fait qu'elle comprend en outre au moins une plage métallisée intermédiaire individuelle intercalée respectivement entre chaque plage de connexion et la plage de drainage, ladite plage intermédiaire étant séparée à la fois de la plage de connexion et de la plage de drainage et étant formée selon un contour rectangulaire allongé perpendiculairement à la direction de déplacement de ladite plaque.

D'autres caractéristiques, buts et avantages de la présente invention apparaitront à la lecture de la description détaillée qui va suivre et en regard des dessins annexés, donnés à titre d'exemples non limitatifs et sur lesquels :
- la figure 1 représente une vue en plan de plages métallisées d'une plaque de circuit imprimé conforme à la présente invention,
- la figure 2 représente une vue en plan de plages métallisées d'une plaque de circuit imprimé conforme à une variante de la présente invention,
- les figures 3 à 7 illustrent schématiquement les étapes successives de transfert de soudure, d'une plage de connexion vers une plage de drainage, sur une plaque de circuit imprimé conforme à la présente invention, et
- les figures 8 et 9 illustrent schématiquement les étapes successives de transfert de soudure, d'une plage de connexion vers une plage de drainage, sur une plaque de circuit imprimé conforme à l'état de la technique.

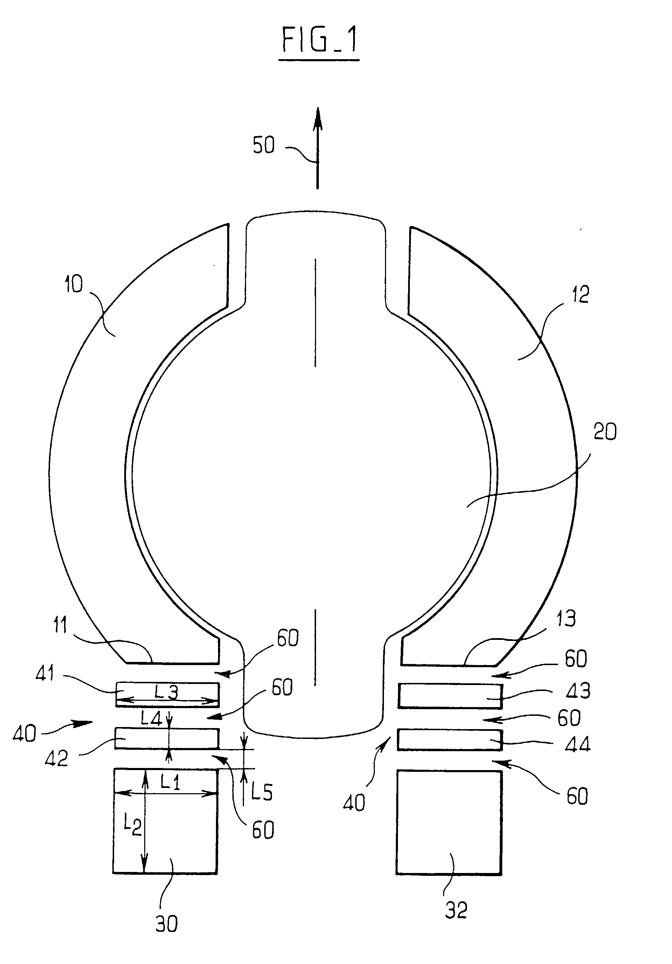

Sur la figure 1 on a représenté sous les références 10 et 12, deux plages métallisées classiques d'un circuit imprimé, destinées à recevoir par exemple, par simple contact mécanique, les connexions de sortie d'une ampoule électrique ou les contacts d'un support recevant celle-ci.

De telles plages de connexion 10 et 12 peuvent faire l'objet de nombreuses variantes de réalisation quant à leur configuration et/ou dimension. Pour cette raison ces plages 10 et 12 ne seront pas décrites dans le détail par la suite.

On notera cependant que selon la représentation de la figure 1, ces plages 10 et 12 sont incurvées autour d'un canal central 20 ménagé dans la plaque de circuit imprimé pour recevoir une ampoule électrique ou son support.

Par ailleurs sur la figure 1 on a représenté sous les références 30 et 32 deux plages de drainage principales. Ces plages de drainage 30 et 32 sont formées de plages métallisées, de même nature que les plages de connexion 10 et 12, avantageusesment en cuivre. Elles sont placées respectivement en aval, par rapport au sens de déplacement de la plaque de circuit imprimé, des plages de connexion 12 et 12.

Sur la figure 1, la direction de passage à la vague est référencée 50

Les plages de drainage 30 et 32 sont de préférence de contour rectangulaire. Leurs bords sont respectivement perpendiculaires et parallèles à la direction de passage à la vague 50.

A titre d'exemple non limitatif, les plages de drainage 30 et 32 peuvent être par exemple de contour carré ayant des côtés L1xL2 de 2,5mm.

Comme on l'a indiqué précédemment selon la présente invention, il est prévu en outre au moins une plage métallisée intermédiaire individuelle 40 intercalée respectivement entre chaque plage de connexion 10, 12 et chaque plage de drainage 30, 32 respectivement associée, ladite plage intermédiaire 40 étant séparée à la fois de la plage de connexion 10, 12 et de la plage de drainage 30, 32.

En outre, cette plage intermédiaire 40 est de contour rectangulaire, allongée perpendiculairement à la direction de déplacement de la plaque pour un passage de soudure à la vague.

Plus précisément selon le mode de réalisation préférentiel représenté sur la figure 1, il est prévu plusieurs plages intermédiaires, typiquement deux plages intermédiaires 40, entre la plage de connexion 10, 12 et chaque plage de drainage 30, 32 respectivement associée.

Les deux plages intermédiaires intercalées entre la plage de connexion 10 et la plage de drainage 30 sont référencées 41 et 42.

Les deux plages intermédiaires intercalées entre la plage de connexion 12 et la plage de drainage 32 sont référencées 43 et 44.

Ces plages intermédiaires 40 sont formées de plages métallisées, de même nature que les plages de connexion 10 et 12 et que les plages de drainage 30 et 32, avantageusement en cuivre.

Les plages intermédiaires 40 ont leurs bords respectivement perpendiculaires et parallèles à la direction de passage à la vague 50. Elles ont de préférence une longueur L3, considérée perpendiculairement au sens de passage à la vague 50, sensiblement égale à la longueur correspondante L1 de la plage de drainage 30, 32 associée et sensiblement égale à la longueur du bord de fuite aval 11, 13 de la plage de connexion associée 10, 12. En revanche elles ont de préférence une largeur L4, considérée parallèlement au sens de passage à la vague 50, nettement inférieure à la largeur L2 correspondante de la plage de drainage associée 30, 32.

A titre d'exemple non limitatif, les plages intermédiaires 40 peuvent posséder par exemple une longueur L3 de l'ordre de 2,5mm et une largeur L4 de l'ordre de 0,5mm.

Par ailleurs la largeur L5 des différents canaux non métallisés 60 formés entre la plage de connexion 10, 12 et la première plage intermédiaire 41, 43, entre les plages intermédiaires 41 et 42, 43 et 44, ainsi qu'entre la dernière plage intermédiaire 42, 44 et la plage de drainage 30, 32, est de préférence la même pour les différents canaux 60.

La largeur L5 de ces canaux 60 est typiquement de l'ordre de 0,4mm.

Les plages intermédiaires 40 et les plages de drainage 30 et 32 sont centrées sur un plan parallèle à la direction de passage à la vague 50 et passant par le milieu du bord de fuite aval 11, 13 des plages de connexion 10 et 12.

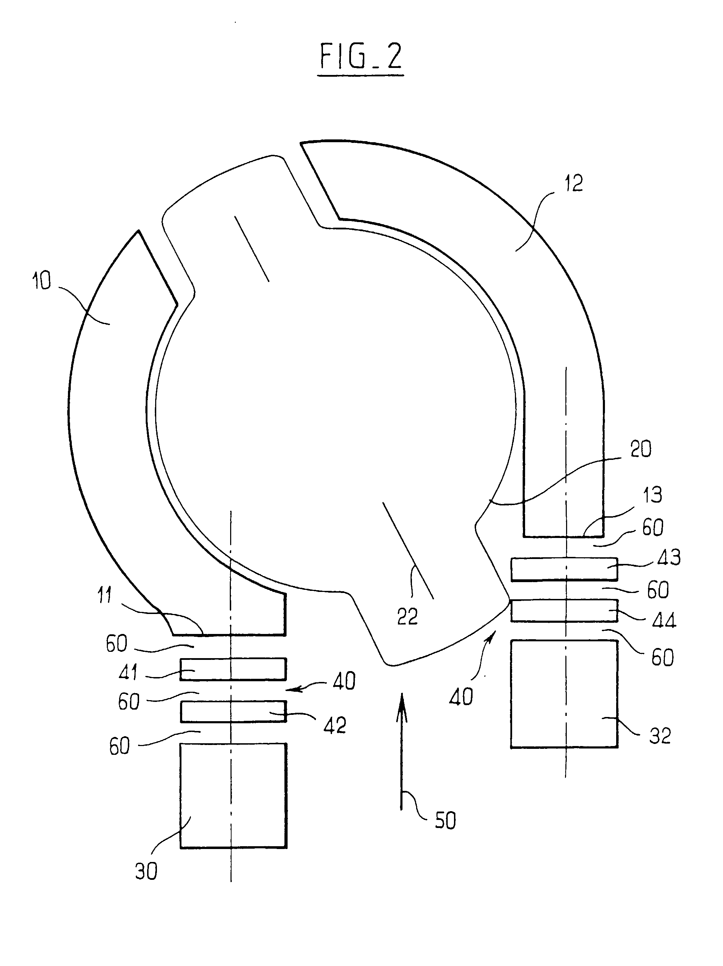

La figure 2 montre une variante de réalisation de la présente invention sur laquelle on retrouve deux plages intermédiaires 41 et 42, 43 et 44 entre chaque plage de connexion 10 et 12 et les plages de drainage 30 et 32 associées.

La figure 2 illustre essentiellement que l'axe 22 du passage traversant 20 peut être incliné de 0 à 45° par exemple, par rapport à la direction de passage à la vague 50.

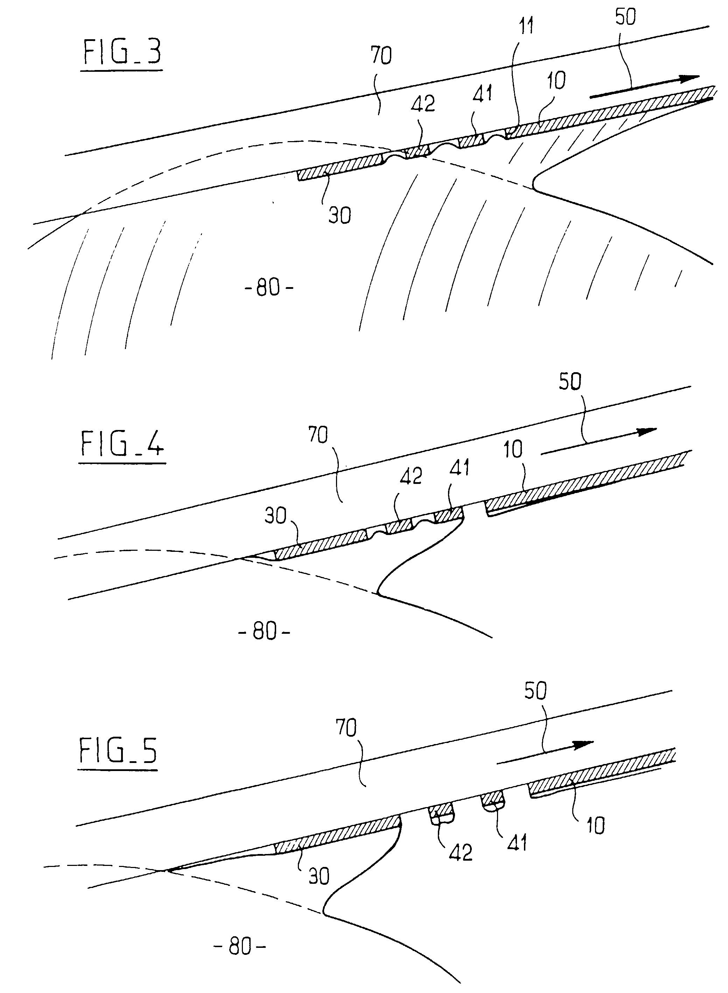

Sur les figures 3 à 9, on a référencé 70 la plaque support du circuit imprimé et on a référencé 80 la vague de soudure.

La figure 3 montre la vague 80 sur une plage de connexion 10 ou 12.

La figure 4 montre le bord de fuite de la vague 80 arrivant sur les plages intermédiaires 40.

La figure 4 montre que les plages intermédiaires 40 permettent à la soudure de glisser et de s'éloigner des plages de connexion 10 et 12.

La figure 5 montre le bord de fuite de la vague 80 arrivant sur une plage de drainage 30 ou 32.

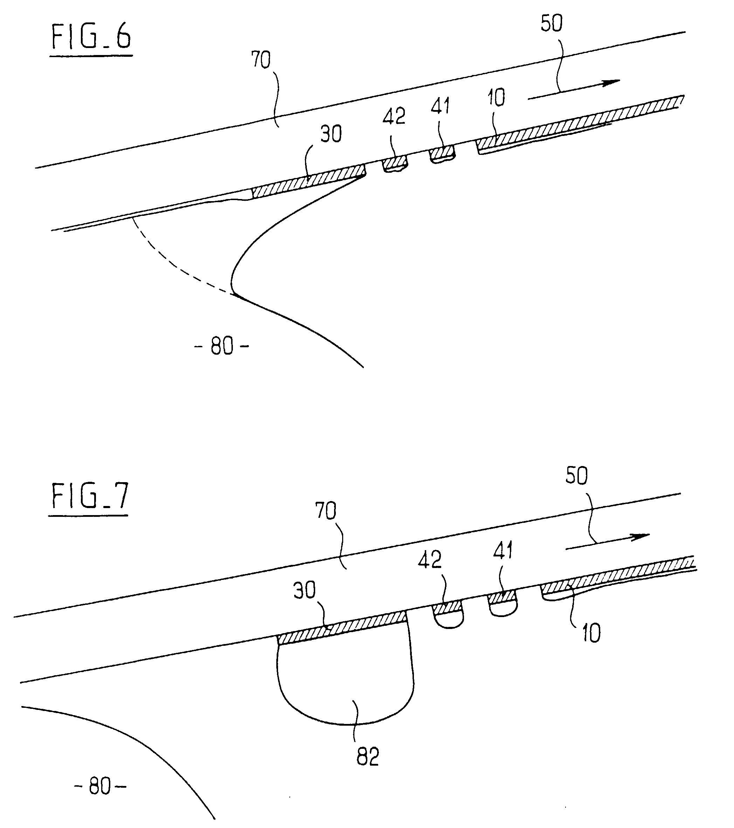

La figure 6 montre le processus dans une étape où le bord de fuite de la vague de soudure 80 s'apprête à atteindre une zone non métallisée de la plaque de circuit imprimé, donc à mauvaise mouillabilité, et par conséquent une goutte d'étain s'apprête à se séparer de la vague 80.

La figure 7 montre que après rupture, cette goutte d'étain 82 retourne sur les zones de cuivre 30, 32 principalement et accessoirement 40, où la mouillabilité est bonne.

On comprend ainsi que le rôle des plages intermédiaires 40 est triple:
- d'une part éloigner les plages de drainage principales 30 et 32, des plages de connexion 10 et 12, tout en permettant au surplus d'étain de glisser hors des plages de connexion 10 et 12;
- d'autre part d'empêcher, lorsque le surplus d'étain se détache de la vague 80, que cette goutte 82 ne revienne sous l'action d'efforts de capillarité ou tension superficelle, sur la plage de connexion en causant une surépaisseur notable;
- enfin de servir de plages de drainage auxilaires.

Les plages intermédiaires conformes à la présente invention permettent ainsi de drainer des plages de connexion 10 et 12 relativement importantes avec des plages de drainage 30 ou 32 de surface minimale.

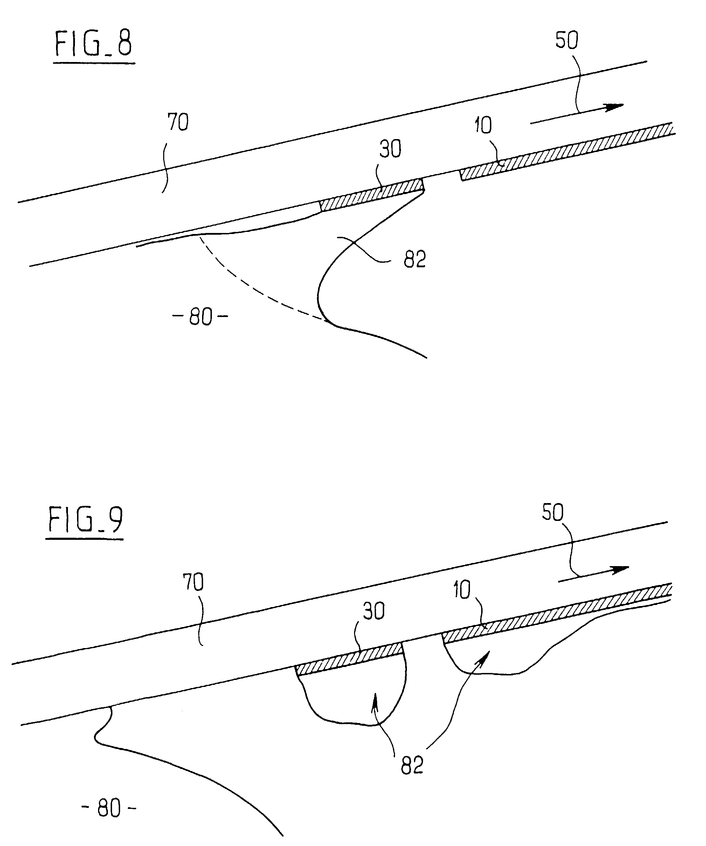

Les figures 8 et 9 montrent que en l'absence des plages intermédiaires conformes à la présente invention, la goutte d'étain 82 aprés séparation de la vague 80, retourne au moins en partie sur les plages de connexion 10 et 12 générant des surépaisseurs non acceptables, notamment pour la connexion d'ampoules électriques ou de leurs supports.

Bien entendu la présente invention n'est pas limitée aux modes de réalisation qui viennent d'être décrits, mais s'étend à toutes variantes telles que décrites dans les revendications.

En particulier, la présente invention n'est pas limitée au drainage de soudure déposée en excès sur des plages de connexion d'ampoules électriques.

## Revendications

1. Plaque de circuit imprimé du type connu comprenant une plage métallisée de drainage (30, 32) en aval de certaines au moins des plages métallisées de connexion (10, 12), par rapport au sens de déplacement de la plaque, pour un passage de soudure à la vague caractérisée par le fait qu'elle comprend en outre au moins une plage métallisée intermédiaire individuelle (40) intercalée respectivement entre chaque plage de connexion (10, 12) et chaque plage de drainage (30, 32), ladite plage intermédiaire (40) étant séparée à la fois de la plage de connexion (10,12) et de la plage de drainage (30, 32), et étant formée selon un contour rectangulaire allongé perpendiculairement à la direction de déplacement de ladite plaque.

2. Plaque selon la revendication 1, caractérisée par le fait qu'il est prévu plusieurs plages intermédiaires (41, 42, 43, 44) entre la plage de connexion (10, 12) et chaque plage de drainage (30, 32) respectivement associée.

3. Plaque selon l'une des revendications 1 ou 2, caractérisée par le fait qu'il est prévu deux plages intermédiaires (41, 42, 43, 44) entre la plage de connexion (10, 12) et chaque plage de drainage (30, 32) respectivement associée.

4. Plaque selon l'une des revendications 1 à 3, caractérisée par le fait que les plages de connexion (10, 12) sont des plages de connexion des sorties d'une ampoule électrique ou des contacts d'un support recevant celle-ci.

5. Plaque selon l'une des revendications 1 à 4, caractérisée par le fait que les plages de drainage (30, 32) sont de contour rectangulaire.

6. Plaque selon l'une des revendications 1 à 5, caractérisée par le fait que les bords des plages de drainage (30, 32) sont respectivement perpendiculaires et parallèles à la direction de passage à la vague (50).

7. Plaque selon l'une des revendications 1 à 6, caractérisée par le fait que les plages de drainage (30, 32) sont de contour carré.

8. Plaque selon l'une des revendications 1 à 7, caractérisée par le fait que les plages de drainage (30, 32) ont des côtés de l'ordre de 2,5mm.

9. Plaque selon l'une des revendications 1 à 8, caractérisée par le fait que les plages intermédiaires (40) sont formées de plages métallisées de même nature que les plages de connexion (10, 12) et que les plages de drainage (30, 32), avantageusement en cuivre.

10. Plaque selon l'une des revendications 1 à 9, caractérisée par le fait que les bords des plages intermédiaires (40) sont respectivement perpendiculaires et parallèles à la direction de passage à la vague 50.

11. Plaque selon l'une des revendications 1 à 10, caractérisée par le fait que les plages intermédiaires (40) ont une longueur (L3), considérée perpendiculairement au sens de passage à la vague (50), sensiblement égale à la longueur correspondante (L1) de la plage de drainage (30, 32) associée et sensiblement égale à la longueur du bord de fuite aval (11, 13) de la plage de connexion associée (10, 12).

12. Plaque selon l'une des revendications 1 à 11, caractérisée par le fait que les plages intermédiaires (40) ont une largeur (L4), considérée parallèlement au sens de passage à la vague (50), nettement inférieure à la largeur (L2) correspondante de la plage de drainage associée (30, 32).

13. Plaque selon l'une des revendications 1 à 12, caractérisée par le fait que les plages intermédiaires (40) possédent une longueur (L3) de l'ordre de 2,5mm et une largeur (L4) de l'ordre de 0,5mm.

14. Plaque selon l'une des revendications 1 à 13, caractérisée par le fait que la largeur (L5) des différents canaux non métallisés (60) formés entre la plage de connexion (10, 12) et la première plage intermédiaire (41, 43), entre les plages intermédiaires (41 et 42, 43 et 44), ainsi qu'entre la dernière plage intermédiaire (42, 44) et la plage de drainage (30, 32), est de préférence la même pour les différents canaux (60).

15. Plaque selon l'une des revendications 1 à 14, caractérisée par le fait que la largeur (L5) des canaux (60) non métallisés formés entre les différentes plages (10, 12, 30, 32, 40) est typiquement de l'ordre de 0,4mm.

16. Plaque selon l'une des revendications 1 à 15, caractérisée par le fait que les plages intermédiaires (40) et les plages de drainage (30, 32) sont centrées sur un plan parallèle à la direction de passage à la vague (50) et passant par le milieu du bord de fuite aval (11, 13) des plages de connexion (10 et 12).

## Patentansprüche

1. Gedruckte Schaltungsplatte bekannter Bauart, mit einem metallisierten Drainageflecken (30, 32) stromabwärts von wenigstens einigen metallisierten Anschlußflecken (10, 12) relativ zur Richtung der Verschiebung der Platte bei einem Durchgang beim Schwallöten, dadurch **gekennzeichnet**, daß sie ferner wenigstens einen einzelnen metallisierten Zwischenflecken aufweist, der jeweils zwischen jeden Anschlußflecken (10, 12) und jeden Drainageflecken (30, 32) geschaltet ist, wobei der Zwischenflecken (40) sowohl von dem Verbindungsflecken (10, 12) als auch von dem Drainageflecken (30, 32) getrennt ist und mit einer rechteckigen Kontur ausgebildet ist, welche senkrecht zur Verschiebungsrichtung der Platte langgestreckt ist.

2. Platte nach Anspruch 1, dadurch **gekennzeichnet**, daß sie mehrere Zwischenflecken (41, 42, 43, 44) zwischen dem Anschlußflecken (10, 12) und jedem entsprechend zugeordneten Drainageflecken (30, 32) aufweist.

3. Platte nach einem der Ansprüche 1 oder 2, dadurch **gekennzeichnet**, daß sie zwei Zwischenflecken (41, 42, 43, 44) zwischen dem Anschlußflecken (10, 12) und jedem entsprechend zugeordneten Drainageflecken (41, 42, 43, 44) aufweist.

4. Platte nach einem der Ansprüche 1 bis 3, dadurch **gekennzeichnet**, daß die Anschlußflecken (10, 12) Ausgangs-Anschlußflecken eines elektrischen Glaskolbens oder Kontakte einer Haltevorrichtung für einen solchen sind.

5. Platte nach einem der Ansprüche 1 bis 4, dadurch **gekennzeichnet**,g e k e n n z e i c h n e t, daß die Drainageflecken (30, 32) eine rechteckige Kontur haben.

6. Platte nach einem der Ansprüche 1 bis 5, dadurch **gekennzeichnet**, daß die Ränder der Drainageflecken (30, 32) jeweils senkrecht und parallel zu der Durchlaufrichtung beim Schwallöten (50) sind.

7. Platte nach einem der Ansprüche 1 bis 6, dadurch **gekennzeichnet**, daß die Drainageflecken (30, 32) eine quadratische Kontur haben.

8. Platte nach einem der Ansprüche 1 bis 7, dadurch **gekennzeichnet**, daß die Drainageflecken (30, 32) Seiten in der Größenordnung von 2,5 mm haben.

9. Platte nach einem der Ansprüche 1 bis 8, dadurch **gekennzeichnet**, daß die Zwischenflecken (40) aus metallisierten Flecken derselben Art wie die Anschlußflecken (10, 12) und die Drainageflecken (30, 32) hergestellt sind, vorzugsweise aus Kupfer.

10. Platte nach einem der Ansprüche 1 bis 9, dadurch **gekennzeichnet**, daß die Ränder der Zwischenflecken (40) jeweils senkrecht und parallel zu der Durchlaufrichtung beim Schwallöten (50) sind.

11. Platte nach einem der Ansprüche 1 bis 10, dadurch **gekennzeichnet**, daß die Zwischenflecken 40 eine Breite (L3) haben, welche senkrecht zur Durchlaufrichtung beim Schwallöten (50) betrachtet ungefähr gleich der entsprechenden Breite (L1) des zugeordneten Drainagefleckens (30, 32) und ungefähr gleich der Breite der stromabwärtigen Hinterkante (11, 13) des zugeordneten Anschlußfleckens (10, 12) ist.

12. Platte nach einem der Ansprüche 1 bis 11, dadurch **gekennzeichnet**, daß die Zwischenflecken (40) eine Breite (L4) haben, die parallel zur Durchlaufrichtung beim Schwallöten (50) betrachtet netto geringer ist als die entsprechende Breite (L2) des zugeordneten Drainagefleckens (30, 32).

13. Platte nach einem der Ansprüche 1 bis 12, dadurch **gekennzeichnet**, daß die Zwischenflecken (40) eine Breite (L3) in der Größenordnung von 2,5 mm und eine Breite (L4) in der Größenordnung von 0,5 mm haben.

14. Platte nach einem der Ansprüche 1 bis 13, dadurch **gekennzeichnet**, daß die Breite (L5) unterschiedlicher nicht metallisierter Kanäle (60), die zwischen den Anschlußflecken (10, 12) und dem ersten Zwischenflecken (41, 43), zwischen den Zwischenflecken (41 und 42, 43 und 44) sowie zwischen dem letzten Zwischenflecken (42, 44) und dem Drainageflecken (30, 32) ausgebildet sind, vorzugsweise für alle unterschiedlichen Kanäle (60) gleich ist.

15. Platte nach einem der Ansprüche 1 bis 14, dadurch **gekennzeichnet**, daß die Breite (L5) der nicht metallisierten Kanäle (60), welche zwischen den unterschiedlichen Flecken (10, 12, 30, 32, 40) ausgebildet sind, üblicherweise in der Größenordnung von 0,4 mm liegen.

16. Platte nach einem der Ansprüche 1 bis 15, dadurch gekennzeichnet, daß die Zwischenflecken (40) und die Drainageflecken (30, 32) auf einer Ebene zentriert sind, die parallel zu der Durchlaufrichtung beim Schwallöten (50) ist und durch die Mitte der stromabwärtigen Hinterkante (11, 13) der Anschlußflecken (10 und 12) geht.

## Claims

1. A printed circuit board of known type including respective metallized drainage pads (30, 32) downstream from at least some metallized connection pads (10, 12) relative to the displacement direction of the board in a wave soldering pass, the board being characterized by the fact that it further comprises at least one individual intermediate metallized pad (40) interposed between each connection pad (10, 12) and each associated drainage pad (30, 32), said intermediate pad (40) being separated both from the connection pad (10, 12) and from the drainage pad (30, 32), and being shaped to have a rectangular outline that is elongate perpendicularly to the displacement direction of said board.

2. A board according to claim 1, characterized by the fact that a plurality of intermediate pads (41, 42, 43, 44) are provided between each connection pad (10, 12) and the drainage pad (30, 32) respectively associated therewith.

3. A board according to claim 1 or 2, characterized by the fact that two intermediate pads (41, 42, 43, 44) are provided between each connection pad (10, 12) and the drainage pad (30, 32) respectively associated therewith.

4. A board according to any one of claims 1 to 3, characterized by the fact that the connection pads (10, 12) are pads for making connection with the outlets of an electric light bulb or with the contacts of a support for receiving the light bulb.

5. A board according to any one of claims 1 to 4, characterized by the fact that the drainage pads (30, 32) are rectangular in outline.

6. A board according to any one of claims 1 to 5, characterized by the fact that the edges of the drainage pads (30, 32) are respectively perpendicular and parallel to the travel direction (50) relative to the wave.

7. A board according to any one of claims 1 to 6, characterized by the fact that the drainage pads (30, 32) are square in outline.

8. A board according to any one of claims 1 to 7, characterized by the fact that the sides of the drainage pads (30, 32) are about 2.5 mm long.

9. A board according to any one of claims 1 to 8, characterized by the fact that the intermediate pads (40) are constituted by metallized pads of the same kind as the connection pads (10, 12) and the drainage pads (30, 32) advantageously being made of copper.

10. A board according to any one of claims 1 to 9, characterized by the fact that the edges of the intermediate pads (40) are respectively perpendicular and parallel to the travel direction (50) relative to the wave.

11. A board according to any one of claims 1 to 10, characterized by the fact that the intermediate pads (40) are of a length (L₃) perpendicularly to the travel direction (50) of the wave that is substantially equal to the corresponding length (L₁) of the associated drainage pad (30, 32) and substantially equal to the length of the downstream trailing edge (11, 13) of the associated connection pad (10, 12).

12. A board according to any one of claims 1 to 11, characterized by the fact that the width (L₄) of the intermediate pads (40) parallel to the travel direction (50) of the wave that is considerably smaller than the corresponding width (L₂) of the associated drainage pad (30, 32).

13. A board according to any one of claims 1 to 12, characterized by the fact that intermediate pads (40) are of a length (L₃) of about 2.5 mm and of a width (L₄) of about 0.5 mm.

14. A board according to any one of claims 1 to 13, characterized by the fact that the width (L₅) of the various non-metallized channels (60) formed between the connection pads (10, 12) and the first intermediate pad (41, 42), between the intermediate pads (41 and 42, 43 and 44) and between the last intermediate pad (42, 44) and the drainage pad (30, 32) is preferably the same for the various channels (60).

15. A board according to any one of claims 1 to 14, characterized by the fact that the width (L₅) of the non-metallized channels (60) formed between the various pads (10, 12, 30, 32, 40) is typically about 0.4 mm.

16. A board according to any one of claims 1 to 15, characterized by the fact that the intermediate pads (40) and the drainage pads (30, 32) are centered on a plane parallel to the travel direction (50) of the wave and passing through the middle of the downstream trailing edge (11, 13) of each connection pad (10, 12).
